# EUROPÄISCHE PATENTSCHRIFT

(11) **EP 4 136 941 B1**
(45) Veröffentlichungstag und Bekanntmachung des Hinweises auf die Patenterteilung: **10.04.2024**
(21) Anmeldenummer: 21721902.1
(22) Anmeldetag: 23.04.2021
(51) Int. Cl.: H05K 3/06, H05K 3/02, B32B 15/00, B32B 15/20, B32B 17/06, C04B 37/02, H05K 3/38, H05K 3/10, H05K 1/02, H05K 1/03, H05K 3/04, H01L 23/15

(54) **TRÄGERSUBSTRAT UND VERFAHREN ZUR HERSTELLUNG EINES TRÄGERSUBSTRATS**
CARRIER SUBSTRATE AND MANUFACTURING PROCESS OF A CARRIER SUBSTRATE
SUBSTRAT DE SUPPORT ET PROCÉDÉ DE FABRICATION D'UN SUBSRTAT DE SUPPORT

(30) Priorität: 29.04.2020 DE 102020111697
(43) Veröffentlichungstag der Anmeldung: 22.02.2023
(73) Patentinhaber: Rogers Germany GmbH, 92676 Eschenbach (DE)
(72) Erfinder: SCHMIDT, Karsten, 92676 Eschenbach (DE); WELKER, Tilo, 91284 Neuhaus (DE); MEYER, Andreas, 95469 Speichersdorf (DE); BRITTING, Stefan, 91220 Schnaittach (DE)
(74) Vertreter: Müller Schupfner & Partner Patent- und Rechtsanwaltspartnerschaft mbB
(86) Internationale Anmeldenummer: PCT/EP2021/060646
(87) Internationale Veröffentlichungsnummer: WO 2021/219503

(56) Entgegenhaltungen:
- EP-A1- 2 447 235
- EP-A2- 0 153 618
- WO-A1-91/16805
- DE-B4- 19 927 046
- JP-A- 2014 172 802
- US-A- 3 217 209
- US-A- 3 867 217

## Beschreibung

Die vorliegende Erfindung betrifft ein Trägersubstrat und ein Verfahren zur Herstellung eines Trägersubstrats.

Trägersubstrate, wie z. B. Metall-Keramik-Substrate, sind als Leiterplatten oder Platinen aus dem Stand der Technik hinlänglich bekannt, beispielsweise aus der DE 10 2013 104 739 A1, der DE 19 927 046 B4 und der DE 10 2009 033 029 A1. Typischerweise werden auf einer Bauteilseite des Metall-Keramik-Substrats bzw. des Trägersubstrats Anschlussflächen für elektrische Bauteile und Leiterbahnen angeordnet, wobei die elektrischen Bauteile und die Leiterbahnen zu elektrischen Schaltkreisen zusammenschaltbar sind. Wesentliche Bestandteile der Metall-Keramik-Substrate sind eine Isolationsschicht, die bevorzugt aus einer Keramik gefertigt ist, und wenigstens eine an die Isolationsschicht angebundene Metallschicht. Wegen ihrer vergleichsweise hohen Isolationsfestigkeiten haben sich aus Keramik gefertigte Isolationsschichten in der Leistungselektronik als besonders vorteilhaft erwiesen. Durch eine Strukturierung der Metallschicht können sodann Leiterbahnen und/oder Anschlussflächen für die elektrischen Bauteile realisiert werden.

Voraussetzung für das erfolgreiche Bereitstellen eines Metall-Keramik-Substrats ist eine dauerhafte Anbindung der Metallschicht an die Keramikschicht. Neben einem sogenannten Direktmetallanbindungsverfahren, d. h. einem DCB- oder DAB-Verfahren, ist es aus dem Stand der Technik bekannt, die Metallschicht über ein Lotmaterial an die Keramikschicht anzubinden (AMB Verfahren).

Unter einem Aktivlotverfahren, z. B. zum Verbinden von Metallschichten oder Metallfolien, insbesondere auch von Kupferschichten oder Kupferfolien, mit Keramikmaterial, ist hier ein Verfahren zu verstehen, welches speziell zum Herstellen von Metall-Keramik-Substraten verwendet wird. Dabei wird bei einer Temperatur zwischen ca. 650-1000°C eine Verbindung zwischen einer Metallfolie, beispielsweise einer Kupferfolie, und einem Keramiksubstrat, beispielsweise einer Aluminiumnitrid-Keramik, unter Verwendung eines Hartlots hergestellt, welches zusätzlich zu einer Hauptkomponente wie Kupfer, Silber und/oder Gold auch ein Aktivmetall enthält. Dieses Aktivmetall, welches beispielsweise wenigstens ein Element aus der Gruppe Hf, Ti, Zr, Nb, Ce ist, stellt durch chemische Reaktion eine Verbindung zwischen dem Lot und der Keramik her, während die Verbindung zwischen dem Lot und dem Metall eine metallische Hartlot-Verbindung ist.

Ferner ist beispielsweise aus der DE 10 2013 113 734 B4, sowie aus der JP 4 - 325 470, ein Verfahren bekannt, bei dem mittels heißisostatischem Pressen eine Anbindung einer Metallschicht an eine Keramikschicht zwecks der Ausbildung eines Metall-Keramik-Substrats vollzogen wird. Das heißisostatische Pressen wird darüber hinaus auch zur Nachbehandlung verwendet, um eine Anzahl an gebildeten Lunkern, die während der Anbindung mit einem Lotverfahren oder mit einem Direktmetallanbindungsverfahren entstehen, zu reduzieren.

Aus der EP 0 153 618 A2 ist ein Anbinden einer Metallschicht an eine Keramikschicht bekannt, indem eine Aktivmetallschicht verwendet wird. Dabei ist die Metallschicht bereits beim Anbinden strukturiert. Aus der WO 91/168 05 A1 wird über ein Lotmaterial eine Bindung zwischen der Keramikschicht und der Metallschicht realisiert, wobei das Lotmaterial strukturiert ist. Das Lotmaterial weist dabei als Bestandteil etwas Aktivmetall auf.

Ausgehend vom Stand der Technik macht es sich die vorliegende Erfindung zur Aufgabe, ein Trägersubstrat, insbesondere ein Metall-Keramik-Substrat, bereitzustellen, das gegenüber den bekannten Trägersubstraten weiter verbessert ist, insbesondere in Hinblick auf einen Aufwand beim Herstellen der Trägersubstrate.

Die vorliegende Erfindung löst diese Aufgabe mit einem Verfahren zur Herstellung eines Trägersubstrats gemäß Anspruch 1 und einem Trägersubstrat gemäß Anspruch 11. Weitere Ausführungsformen sind den abhängigen Ansprüchen und der Beschreibung zu entnehmen.

Gemäß einem ersten Aspekt der vorliegenden Erfindung ist ein Verfahren zur Herstellung eines Trägersubstrats, insbesondere eines Metall-Keramik-Substrates, vorgesehen, umfassend:
- Bereitstellen mindestens einer Metallschicht und eines Isolationselements, insbesondere eines Keramikelements, eines Glaselements, eines Glaskeramikelements und/oder eines hochtemperaturbeständigen Kunststoffelements, wobei sich die mindestens eine Metallschicht und das Isolationselement entlang einer Haupterstreckungsebene erstrecken,
- Anordnen der mindestens einen Metallschicht und des Isolationselements in einer senkrecht zur Haupterstreckungsebene verlaufenden Stapelrichtung übereinander, wobei zwischen der mindestens einen Metallschicht und dem Isolationselement eine Aktivmetallschicht angeordnet wird, wobei die Aktivmetallschicht einen Anteil an Aktivmetall aufweist, der größer ist als 15 Gew.- % und
- Anbinden der mindestens einen Metallschicht an das Isolationselement über die Aktivmetallschicht unter Ausbildung einer Bindungsschicht zwischen der mindestens einen Metallschicht und dem Isolationselement,
wobei die Bindungsschicht strukturiert ausgebildet wird, wobei zur Ausbildung der strukturierten Bindungsschicht zwischen dem Isolationselement und der mindestens eine Metallschicht zumindest bereichsweise eine der Komponenten fehlt, die zur Bindung beitragen, oder die zur Bindung beitragenden Komponenten auf Abstand gehalten werden.

Im Gegensatz zum Stand der Technik ist es vorliegend vorgesehen, dass gezielt eine strukturierte Bindungsschicht, d. h. eine Bindungsschicht mit Unterbrechungen realisiert wird. Dies erweist sich unter anderem deswegen als vorteilhaft, weil dadurch ein aufwendiges "second-etching" vereinfacht werden kann, bei dem die Bindungsschicht, insbesondere eine Haftvermittlerschicht, mit der die mindestens eine Metallschicht an das Isolationselement angebunden ist, wieder entfernt werden muss. Ein umfassendes bzw. intensives "second etching", das der finalen Isolation zweier benachbarter Metallabschnitte in der mindestens einen Metallschicht dient, wirkt sich allerdings negativ sowohl auf die Breite von Isolationsgräben als auch auf eine Form der Grenzlinie zwischen der mindestens einen Metallschicht und dem Isolationselement aus. Im Gegensatz dazu kann mit dem vorliegenden Verfahren zumindest in den Bereichen ohne Bindung in der Bindungsschicht auf das "second etching" verzichtet werden.

Weiterhin ist unter Strukturierung eine gezielte Festlegung von Bereichen bzw. Abschnitten ohne Bindung zwischen dem Isolationselement und der mindestens einen Metallschicht zu verstehen. Dabei wird die Strukturierung gezielt und reproduzierbar hergestellt.

Vorzugsweise ist das Trägersubstrat als Leiterplatte vorgesehen, bei der im gefertigten Zustand die mindestens eine Metallschicht, die an das Isolationselement angebunden ist, strukturiert ist. Beispielsweise ist es hierzu vorgesehen, dass nach dem Anbindungsschritt auch eine Strukturierung, beispielsweise durch Lasern, Ätzen und/oder eine mechanische Bearbeitung, vorgenommen wird, mit der Leiterbahnen und/oder Anschlüsse für elektrische oder elektronische Bauteile realisiert werden. Vorzugsweise ist es vorgesehen, dass an der der mindestens einen Metallschicht gegenüberliegenden Seite am Keramikelement eine weitere Metallschicht, insbesondere eine Rückseitenmetallisierung und/oder ein Kühlelement, vorgesehen ist. Dabei dient die Rückseitenmetallisierung vorzugsweise dazu, einer Durchbiegung entgegenzuwirken und das Kühlelement dient einem wirkungsvollen Abführen von Wärme, die im Betrieb von elektrischen bzw. elektronischen Bauteilen ausgeht, die an die Leiterplatte, bzw. das Metall-Keramik-Substrat angebunden sind.

Als Materialien für die mindestens eine Metallschicht und/oder die mindestens eine weitere Metallschicht im Metall-Keramik-Substrat bzw. Trägersubstrat sind Kupfer, Aluminium, Molybdän, Wolfram und/oder deren Legierungen wie z. B. CuZr, AlSi oder AlMgSi, sowie Laminate wie CuW, CuMo, CuAl und/oder AlCu oder MMC (metal matrix composite), wie CuW, CuM oder AlSiC, vorstellbar. Weiterhin ist bevorzugt vorgesehen, dass die mindestens eine Metallschicht am gefertigten Metall-Keramik-Substrat, insbesondere als Bauteilmetallisierung, oberflächenmodifiziert ist. Als Oberflächenmodifikation ist beispielsweise eine Versiegelung mit einem Edelmetall, insbesondere Silber; und/oder Gold, oder (electroless) Nickel oder ENIG ("*electroless nickel immersion gold*") oder ein Kantenverguss an der Metallisierung zur Unterdrückung einer Rissbildung bzw. -weitung denkbar.

Vorzugsweise weist das Keramikelement Al₂O₃, Si₃N₄, AIN, eine HPSX-Keramik (d. h. eine Keramik mit einer Al₂O₃- Matrix, die einen x-prozentigen Anteil an ZrO₂ umfasst, beispielsweise Al₂O₃ mit 9% ZrO₂ = HPS9 oder Al₂O₃ mit 25% ZrO₂ = HPS25), SiC, BeO, MgO, hochdichtes MgO (> 90% der theoretischen Dichte), TSZ (tetragonal stabilisiertes Zirkonoxid) als Material für die Keramik auf. Es ist dabei auch vorstellbar, dass das Keramikelement als Verbund- bzw. Hybridkeramik ausgebildet ist, bei der zur Kombination verschiedener gewünschter Eigenschaften mehrere Keramikschichten, die sich jeweils in Hinblick auf ihre materielle Zusammensetzung unterscheiden, übereinander angeordnet und zu einem Isolationselement zusammengefügt sind

Beispiele für ein Aktivmetall sind Titan (Ti), Zirkonium (Zr), Hafnium (Hf), Chrom (Cr), Niob (Nb), Cer (Ce), Tantal (Ta), Magnesium (Mg), Lanthan (La) und Vanadium (V). Hierbei ist zu beachten, dass die Metalle La, Ce, Ca und Mg leicht oxidieren können. Ferner wird angemerkt, dass die Elemente Cr, Mo und W keine klassischen Aktivmetalle sind, sich aber als Kontaktschicht zwischen Si₃N₄ und der mindestens einen Metallschicht bzw. dem Lotsystem bzw. Lotmaterial eignen, da sie mit der mindestens einen Metallschicht, beispielsweise Kupfer, keine intermetallischen Phasen bilden und keine Randlöslichkeit haben.

Erfindungsgemäß weist die Aktivmetallschicht einen Anteil an Aktivmetall auf, der größer ist als 15 Gew.- %, bevorzugt größer als 25 Gew.-% und besonders bevorzugt größer als 60 Gew.-%. Insbesondere handelt es sich bei der Aktivmetallschicht um keine Lotschicht mit Aktivmetallanteil, sondern um eine vorwiegend aus Aktivmetall gebildete Schicht. Vorzugsweise ist die Aktivmetallschicht keine Lötpaste mit Aktivmetallanteil.

Vorzugsweise wird neben der Aktivmetallschicht ein Lotbasismaterial verwendet, das zwischen der Aktivmetallschicht und der mindestens einen Metallschicht angeordnet wird. Insbesondere handelt es sich bei dem Lotbasismaterial um ein metallbasiertes Basismaterial, vorzugsweise um ein silberbasiertes oder ein kupferbasiertes Basismaterial. In einem silberbasierten Basismaterial ist Silber die Hauptkomponente, d. h. der Bestandteil mit dem bezüglich der Gewichtsprozente höchsten Anteil, während in einem kupferbasierten Basismaterial Kupfer die Hauptkomponente ist. Beispiele für ein silberbasiertes Basismaterial sind AgCu, insbesondere AgCu28, AgCuln, AgCuSn und AgCuGa. Beispiele für ein kupferbasiertes Basismaterial sind Kupfer CuSn, CuAg, Culn, CuGa, CuInSn, CuInMn, CuGaSn. Auch ist es vorstellbar ein Lotbasismaterial auf Basis von NiCrMn oder SnCu zu verwenden. Es ist auch vorstellbar, dass ein silberfreies Lotbasismaterial verwendet wird. Bevorzugt ist es vorgesehen, dass das Aktivmetall ausschließlich in der Aktivmetallschicht ist und nicht im Lotbasismaterial. Mit anderen Worten: Es wird vorzugsweise ein aktivmetallfreies Lotbasismaterial verwendet.

Vorzugsweise ist es vorgesehen, dass eine Aktivmetallschicht realisiert wird, deren Dicke zwischen 10 nm und 1000 nm liegt, bevorzugt zwischen 50 nm und 750 nm, besonders bevorzugt zwischen 100 und 500 nm. Weiterhin ist es bevorzugt vorgesehen, dass das Aktivmetall mittels eines physikalischen Gasphasenabscheidens auf dem Isolationselement, der mindestens einen Metallschicht und/oder dem Lotbasismaterial, das vorzugsweise ebenfalls als Folie ausgebildet ist, aufgetragen wird. Beispielsweise ist es auch vorstellbar, dass das Aktivmetall zusammen mit dem Lotbasismaterial auf die gewünschte Dicke heruntergewalzt wird, um eine vergleichsweise dünne Bindungsschicht zwischen der mindestens einen Metallschicht und dem Isolationselement auszubilden. Vorzugsweise wird eine Lotfolie verwendet, die eine Dicke zwischen 2 und 20 µm, bevorzugt kleiner als 12 µm und besonders bevorzugt kleiner als 8 µm aufweist und/oder kleiner ist als 0,01 mm, bevorzugt kleiner als 0,005 mm und besonders bevorzugt kleiner als 0,001 oder sogar kleiner als 0,0005 mm, wenn die Bindungsschicht durch die Haftvermittlerschicht realisiert ist. Weiterhin ist es vorstellbar, dass das Lotbasismaterial als Folie, als Paste, als eine durch physikalisches Gasphasenabscheiden entstandene Schicht und/oder als elektrochemisch gebildete Schicht bereitgestellt wird. Es ist auch vorstellbar, dass das Lotbasismaterial durch ein elektrochemisches, chemisches oder physikalisches Gasphasenabscheideverfahren aufgetragen wird.

Weiterhin ist es vorgesehen, dass die Aktivmetallschicht strukturiert wird, indem sie zunächst flächig ausgebildet wird und anschließend gezielt Bereiche zur Strukturierung wieder entfernt werden, beispielsweise durch Laserlicht und/oder durch Ätzen.

Weiterhin ist es bevorzugt vorgesehen, dass die mindestens eine Metallschicht und/oder die mindestens eine weitere Metallschicht mittels eines Aktivlotverfahrens und/oder eines heißisostatischen Pressens angebunden wird. Beispielsweise ist ein Verfahren zur Herstellung eines Trägersubstrats vorgesehen, umfassend:
- Bereitstellen einer Lötschicht, insbesondere in Form mindestens einer Lötfolie bzw. Hartlotfolie,
- Beschichten des Isolationselements und/oder der mindestens einen Metallschicht und/oder der mindestens einen Lötschicht mit der Aktivmetallschicht,
- Anordnen der mindestens einen Lötschicht zwischen dem Isolationselement und der mindestens einen Metallschicht entlang einer Stapelrichtung unter Ausbildung eines Lötsystems, das die Lötschicht und die Aktivmetallschicht umfasst, wobei ein Lotmaterial der mindestens einen Lötschicht vorzugsweise frei von einem schmelzpunkterniedrigenden Material ist, und
- Anbinden der mindestens einen Metallschicht an die mindestens eine Keramikschicht über das Lötsystem mittels eines Aktivlotverfahrens. Dabei wird die Lötschicht vorzugsweise aus einem aktivmetallfreien Lötbasismaterial gebildet.

Insbesondere ist dabei ein mehrschichtiges Lötsystem aus der Lötschicht, vorzugsweise frei von schmelzpunkterniedrigenden Elementen oder frei von Phosphor, besonders bevorzugt aus einer phosphorfreien Lötschicht, und der Aktivmetallschicht, vorgesehen. Die Separation der Aktivmetallschicht und der Lötschicht erweist sich insbesondere deswegen als vorteilhaft, weil dadurch vergleichsweise dünne Lötschichten realisierbar sind, insbesondere wenn es sich bei der Lötschicht um eine Folie handelt. Für aktivmetallhaltige Lötmaterialien müssen andernfalls vergleichsweise große Lötschichtdicken wegen der spröden intermetallischen Phasen bzw. des hohen E-Moduls und hoher Streckgrenze der gängigen Aktivmetalle und deren intermetallischen Phasen, die die Umformung der Lötpaste bzw. Lötschicht behindern, realisiert werden, wodurch die minimale Schichtdicke durch die Fertigungseigenschaften des aktivmetallhaltigen Lötmaterials begrenzt wird. Entsprechend bestimmt für aktivmetallhaltige Lötschichten nicht die für das Fügeverfahren erforderliche Mindestdicke die minimale Lötschichtdicke der Lötschicht, sondern die für die technisch realisierbare minimale Schichtdicke der Lötschicht bestimmt die minimale Lötschichtdicke der Lötschicht. Dadurch ist diese dickere, aktivmetallhaltige Lötschicht teurer als dünne Schichten. Unter phosphorfrei versteht der Fachmann insbesondere, dass der Anteil an Phosphor in der Lötschicht kleiner ist als 150 ppm, kleiner als 100 ppm und besonders bevorzugt kleiner als 50 ppm.

Vorzugsweise umfasst die Lötschicht, insbesondere die phosphorfreie Lotschicht, mehrere Materialien zusätzlich zu dem reinen Metall. Beispielsweise ist Indium ein Bestandteil des verwendeten Lotmaterials in der Lötschicht.

Weiterhin ist es vorstellbar, dass das Lotmaterial zur Ausbildung der Lötschicht durch ein physikalisches und/oder chemisches Gasphasenabscheiden und/oder elektrochemisch auf die Aktivmetallschicht und/oder die mindestens eine Metallschicht aufgetragen wird. Dadurch ist es in vorteilhafter Weise möglich, vergleichsweise dünne Lotschichten im Lötsystem, insbesondere in einer homogenen Verteilung, zu realisieren.

Alternativ oder ergänzend sind bei der Herstellung des Trägersubstrats, insbesondere des Metall-Keramik-Substrats, die weiteren Schritte vorgesehen, umfassend:
- Ausbilden eines gasdichten Metallbehälters, der das Isolationselement umschließt,
- Ausbilden des Metall-Keramik-Substrats durch ein Anbinden des Metallbehälters an das Isolationselement mittels heißisostatischem Pressen,
wobei beim Ausbilden des Metall-Keramik-Substrats zwischen dem Metallbehälter und dem Keramikelement mindestens abschnittsweise die Aktivmetallschicht zur Unterstützung des Anbindens des Metallbehälters an das Keramikelement angeordnet ist bzw. wird. Vorzugsweise wird beim heißisostatischen Pressen eine zusätzliche Lötschicht aus einem Lotbasismaterial, insbesondere einem aktivmetallfreien Lotbasismaterial, zwischen der Aktivmetallschicht und der mindestens einen Metallschicht angeordnet. Der Metallbehälter wird dabei vorzugsweise aus einer ersten Metalllage und einer zweiten Metalllage oder durch ein Falten der ersten Metalllage geformt.

Beim heißisostatischen Pressen ist es insbesondere vorgesehen, dass das Bonden durch Erhitzen unter Druck erfolgt, wobei die erste und/oder zweite Metalllage des Metallbehälters, insbesondere die spätere Metallschicht des Metall-Keramik-Substrats und eine etwaige dort auftretende eutektische (Oxid)schicht nicht in die Schmelzphase übertritt. In entsprechender Weise sind beim heißisostatischem Pressen geringere Temperaturen als bei einem Direktmetallanbindungsverfahren, insbesondere einem DCB-Verfahren, erforderlich.

Im Vergleich zu der Anbindung einer Metallschicht an eine Keramikschicht mittels eines Lotmaterials, bei dem üblicherweise Temperaturen unterhalb der Schmelztemperatur der mindestens einen Metallschicht verwendet werden, kann bei dem heißisostatischen Pressen in vorteilhafter Weise auf ein Lotbasismaterial verzichtet werden und es wird lediglich ein Aktivmetall benötigt. Die Verwendung bzw. die Nutzung des Drucks beim heißisostatischen Pressen erweist sich dabei zudem als vorteilhaft, weil dadurch Lufteinschlüsse zwischen der ersten Metalllage und/oder der zweiten Metalllage einerseits und dem Keramikelement andererseits reduziert werden können, wodurch die Ausbildung von Lunkern in ihrer Häufigkeit im gebildeten bzw. gefertigten Metall-Keramik-Substrat reduziert oder gar vermieden werden kann. Dies wirkt sich vorteilhaft auf die Qualität der Bindung zwischen der Metallschicht bzw. der ersten und/oder zweiten Metalllage des Metallbehälters und dem Keramikelement aus.

Vorzugsweise ist es vorgesehen, dass bei einem heißisostatischen Pressen der Metallbehälter in einer Heiz- und Druckvorrichtung einem Gasdruck zwischen 100 und 2000 bar, bevorzugt 150 bar und 1200 bar und besonders bevorzugt zwischen 300 und 1000 bar und einer Prozesstemperatur von 300 °C bis zu einer Schmelztemperatur der mindestens einen Metallschicht, insbesondere bis zu einer Temperatur unterhalb der Schmelztemperatur der mindestens einen Metallschicht, ausgesetzt wird. Es hat sich in vorteilhafter Weise herausgestellt, dass es so möglich ist, eine Metallschicht, d.h. ein erste und/oder zweite Metalllage des Metallbehälters, an das Keramikelement anzubinden, ohne die erforderlichen Temperaturen eines Direktmetallanbindungsverfahrens, beispielsweise eines DCB- oder einem DAB-Verfahrens, und/oder ohne ein Lotbasismaterial, das beim Aktivloten verwendet wird. Darüber hinaus gestattet das Nutzen bzw. die Verwendung eines entsprechenden Gasdrucks die Möglichkeit, möglichst lunkerfrei, d. h. ohne Gaseinschlüsse zwischen Metallschicht und Keramikelement ein Metall-Keramik-Substrat zu fertigen. Insbesondere finden Prozessparameter Verwendung, die in der DE 2013 113 734 A1 erwähnt werden und auf die hiermit explizit Bezug genommen wird.

Vorzugsweise ist es vorgesehen, dass die Bindungsschicht derart strukturiert ist, dass ein Abstand zwischen zwei Bindungsabschnitten in der Bindungsschicht einen Wert zwischen 200 µm und 5 cm, bevorzugt zwischen 300 µm und 0,5 cm und besonders bevorzugt zwischen 500 µm oder 400 µm und 10 mm annimmt. Ein derartiger Abstand schließt insbesondere die in der Regel kleineren Unterbrechungen aus, die auf fehlerhafte Lunker oder ähnliche Fehlstellen zurückzuführen sind.

Gemäß einer bevorzugten Ausführungsform der vorliegenden Erfindung ist es vorgesehen, dass zur Ausbildungen von strukturierten Unterbrechungen in der Bindungsschicht vor dem Anbindungsprozess in der Bindungsschicht die Aktivmetallschicht und/oder das Isolationselement strukturiert bereitgestellt wird. Vorzugsweise ist es vorgesehen, dass die Aktivmetallschicht derart strukturiert ist, dass ihre Strukturierung in Stapelrichtung gesehen im Wesentlichen bzw. zumindest abschnittsweise deckungsgleich verläuft zur geplanten Strukturierung in der mindestens einen Metallschicht des gefertigten Trägersubstrats. Dadurch werden bereits mit der Aktivmetallschicht die Bereiche von der Ausbildung einer Bindungsschicht ausgelassen, in denen ohnehin vorgesehen ist, dass das Metall der mindestens einen Metallschicht im Rahmen eines Ätzprozesses und/oder durch eine mechanische Bearbeitung und/oder mit Laserlicht wieder entfernt werden soll. Es ist beispielsweise auch vorstellbar, dass das Lotbasismaterial strukturiert bereitgestellt wird und die Aktivmetallschicht durchgängig bzw. ununterbrochen ausgebildet ist. Erfindungsgemäß ist es vorgesehen, dass zur Ausbildung der strukturierten Bindungsschicht zwischen dem Isolationselement und der mindestens einen Metallschicht zumindest bereichsweise eine der Komponenten fehlt, die zur Bindung beitragen, oder die zur Bindung beitragenden Komponenten werden auf Abstand gehalten. Es ist auch denkbar, dass die Strukturierung nach einem Auftragen der Aktivmetallschicht, insbesondere einer flächigen und geschossenen Aktivmetallschicht, erfolgt, beispielsweise indem Bereich in der Aktivmetallschicht gezielt wieder entfernt werden, insbesondere durch Ätzen und/oder Lasern. Es ist auch vorstellbar, dass eine Trennschicht oder Sperrschicht auf die Aktivmetallschicht aufgetragen wird, die verhindert, dass das Isolationselement in bestimmten Bereichen vom Aktivmetall benetzt wird. D. h. es ist vorgesehen, dass auf das Isolationselement und/oder die Aktivmetallschicht eine Maskierung aufgedruckt bzw. angeordnet wird, beispielsweise in Form einer Schattenmaske oder einer Photoresistschicht, die verhindert, dass eine Anbindung der Metallschicht und/oder des Lotmaterials erfolgt, wodurch ebenfalls eine gezielte Unterbindung der lokalen Bildung eines Teils einer Bindungsschicht erreicht wird. Weiterhin ist es vorgesehen, dass die Strukturierung in der Bindungsschicht zwei Bindungsabschnitte durch einen sich länglich erstreckenden Graben und/oder zueinander schräg verlaufende Gräben voneinander trennt.

Insbesondere ist es auch vorstellbar, dass nach einem (voll-)flächigen Auftragen der Aktivmetallschicht auf der mindestens einen Metallschicht die Strukturierung der Aktivmetallschicht dadurch vorgenommen wird, dass sowohl Material der Aktivmetallschicht als auch Material der mindestens einen Metallschicht wieder entfernt wird. Hierzu wird beispielsweise mittels eines mechanischen Vorgangs, beispielsweise mittels eines spanenden Vorgangs, wie einem Fräsen, eine Struktur in die mindestens eine Metallschicht eingelassen, insbesondere auf der Seite, auf der die Aktivmetallschicht aufgebracht wurde. Alternativ kann mittels Laserlicht und/oder durch ein Ätzen Material der Aktivmetallschicht und der mindestens einen Metallschicht entfernt werden. Vorstellbar ist auch, dass die mindestens eine Metallschicht zunächst strukturiert wird und anschließend die strukturierte mindestens eine Metallschicht mit der Aktivmetallschicht bedeckt wird. Dadurch lässt sich ebenfalls sicherstellen, dass das Aktivmetall ausreichend von dem Keramikelement beabstandet ist, wodurch mit Vorteil keine stoffschlüssige Verbindung zwischen Keramikelement und der mindestens einen Metallschicht entsteht.

Die Strukturierung der Aktivmetallschicht, insbesondere zusammen mit der mindestens einen Metallschicht, erweist sich insbesondere als vorteilhaft für solche Metallschichten, die Dicken aufweisen, die größer als 1,5 mm, bevorzugt größer als 2,5 mm und besonders bevorzugt größer als 3 mm sind. Dadurch lassen sich beispielsweise vergleichsweise schmale Isolationsgräben realisieren.

Weiterhin ist es vorstellbar, dass der bis in die mindestens eine Metallschicht hineinreichende Graben eine Tiefe aufweist, wobei ein Verhältnis der Tiefe in der mindestens einen Metallschicht zu einer Dicke der mindestens einen Metallschicht einen Wert zwischen 0,3 und 0,95, bevorzugt zwischen 0,35 und 0,8 und besonders bevorzugt zwischen 0,4 und 0,6 annimmt. Dadurch kann zum einen sichergestellt werden, dass auf der einen Seite ein ausreichender Abstand zwischen der mindestens einen Metallschicht und dem Keramikelement vorliegt und auf der anderen Seite nur ein vergleichsweise geringer Materialabtrag erforderlich ist, um die Isolationsgräben nach dem Anbinden der mindesten einen Metallschicht wieder freizulegen. Hierzu wird vor dem Abtragen des Metalls die Metallschicht mit der Seite an das Keramikelement angebunden, in die die Gräben eingelassen sind.

Es ist auch vorstellbar, dass das Isolationselement an seiner Oberseite durch entsprechende Erhöhungen und/oder Vertiefungen eine Strukturierung aufweist bzw. ausbildet. Beispielsweise ist es vorstellbar, dass eine Sollbruchlinie eingebracht wird in das Isolationselement, insbesondere in das Keramikelement, bevor die Anbindung der mindestens einen Metallschicht an das Keramikelement erfolgt. Dadurch lässt sich ein erforderlicher Abstand zwischen dem Isolationselement und der mindestens einen Metallschicht realisieren, der eine Anbindung der mindestens einen Metallschicht an das Isolationselement in diesem strukturierten Bereich des Isolationselement verhindert. Als strukturierter Bereich wird hierbei insbesondere ein Rücksprung an der Oberseite des Isolationselements verstanden. Weiterhin ist es bevorzugt vorgesehen, dass ein Lotbasismaterial verwendet wird, das insbesondere zwischen der mindestens einen Metallschicht und dem Isolationselement angeordnet wird. Dabei kann das Lotbasismaterial beispielsweise geschlossen, d. h. frei von Strukturierungen, ausgebildet sein. Wegen der Strukturierung der Aktivmetallschicht erfolgt dann dennoch keine Anbindung in den Bereichen, die in der Aktivmetallschicht strukturiert sind.

Insbesondere ist es vorgesehen, dass das Lotbasismaterial strukturiert wird oder strukturiert bereitgestellt wird. Beispielsweise ist es vorstellbar, dass das Lotbasismaterial zusammen mit der Aktivmetallschicht als Lotsystem bereitgestellt wird und das Lotsystem ist strukturiert. Dabei ist es beispielsweise vorstellbar, dass das Aktivmetall durch ein physikalisches Gasabscheiden auf das Lotbasismaterial aufgetragen wird oder Lotbasismaterial und Aktivmetallschicht werden jeweils als Folie bereitgestellt, die zusammen runtergewalzt werden auf die gewünschte Dicke. Anschließend wird das Lotsystem, beispielsweise durch ein Stanzen und Prägen strukturiert. Denkbar ist auch, dass die Strukturierung durch ein Ätzen und/oder mit Laserlicht erfolgt, bevor das Lotsystem auf dem Isolationselement und/oder der mindestens einen Metallschicht angeordnet wird. Alternativ ist es auch vorstellbar, dass das Lotbasismaterial mittels eines physikalischen Gasphasenabscheidens, auf das Aktivmetallschicht aufgetragen wird, beispielsweise mit Hilfe derselben Maskierung, die für die Aktivmetallschicht beim Auftragen der Aktivmetallschicht auf das Isolationselement genutzt wurde. Ferner ist es vorstellbar, dass zur Strukturierung die Aktivmetallschicht nach ihrem Auftragen bereichsweise wieder abgetragen wird.

Vorzugsweise ist es vorgesehen, dass die Aktivmetallschicht als Folie mit Unterbrechungen zur Ausbildung der strukturierten Bindungsschicht bereitgestellt wird. Alternativ oder ergänzend ist es vorstellbar, dass die Aktivmetallschicht durch ein physikalisches Gasphasenabscheiden strukturiert auf das Isolationselement, ein Lotbasismaterial und /oder die mindestens eine Metallschicht aufgetragen wird.

Ein weiterer Gegenstand der vorliegenden Erfindung ist ein Trägersubstrat, insbesondere ein Metall-Keramik-Substrat, als Träger für elektrische Bauteile, umfassend:
- mindestens eine Metallschicht und
- ein Isolationselement, insbesondere ein Keramikelement, ein Glaselement, ein Glaskeramikelement und/oder ein hochtemperaturbeständiges Kunststoffelement, wobei sich die mindestens eine Metallschicht und das Isolationselement entlang einer Haupterstreckungsebene erstrecken und entlang einer senkrecht zur Haupterstreckungsebene verlaufenden Stapelrichtung übereinander angeordnet sind, wobei im Trägersubstrat eine Bindungsschicht zwischen der mindestens einen Metallschicht und dem Isolationselement ausgebildet ist,
wobei die Bindungsschicht vor einem Bilden von Metallabschnitten in der mindestens einen Metallschicht strukturiert ist. Alle für das Verfahren beschriebenen Vorteile lassen sich analog auf das Trägersubstrat übertragen und andersrum.

Gegenüber den aus dem Stand der Technik bekannten Trägersubstraten zeichnet sich das erfindungsgemäße Trägersubstrat dadurch aus, dass die Bindungsschicht vor einem Bilden von Metallabschnitten strukturiert ist. Damit bezieht sich der Gegenstand insbesondere auf ein Zwischenprodukt, bei dem die Metallschicht zwar bereits durch einen entsprechenden Anbindungsprozess an das Isolationselement angebunden wurde, aber noch keine Metallabschnitte in der mindestens einen Metallschicht gebildet wurden, um die Metallschicht zur Ausbildung von Leiterbahnen oder Anschlussflächen zu strukturieren. Beispielsweise handelt es sich um ein als Großkarte vorliegendes Trägersubstrat. Insbesondere sind an dem Isolationselement im vorher strukturierten Bereich keine Rückstände einer Haftvermittlerschicht zu erkennen. Dies resultiert aus dem Umstand, dass zur Herstellung des erfindungsgemäßen Trägersubstrats das erforderliche Aktivmetall strukturiert auf dem Lotmaterial und/oder dem Isolationselement aufgetragen wird, und/oder nachträglich lokal beispielsweise durch Ätzen und/oder mit Laserlicht wieder entfern wird.

Vorzugsweise weist eine Haftvermittlerschicht der Bindungsschicht einen Flächenwiderstand aufweist, der größer als 5 Ohm/sq, bevorzugt größer als 10 Ohm/sq und besonders bevorzugt größer als 20 Ohm/sq ist. Vorzugsweise ist neben dem Silber, das auf ein silberbasiertes Lotmaterial bzw. auf ein silberbasiertes Lotbasismaterial zurückzuführen ist, in der Bindungsschicht eine Haftvermittlerschicht ausgebildet. Im Falle eines Metall-Keramik-Substrats wird die Haftvermittlerschicht dabei vorzugsweise durch eine Verbindung realisiert bzw. ausgebildet, die zum einen das Aktivmetall, beispielsweise Titan, und zum anderen die Bestandteil des Keramikelements, beispielsweise Sauerstoff O, Stickstoff N und/oder Kohlenstoff C und/oder Silizium Si und/oder Aluminium Al und/oder Magnesium Mg und/oder Calcium Ca umfasst. In entsprechender Weise umfasst die Haftvermittlerschicht beispielsweise Titannitrid, Titancarbid und/oder Titanoxid, insbesondere in verschiedenen Oxidationsstufen.

Gegenüber den aus dem Stand der Technik bekannten Trägersubstraten ist es erfindungsgemäß vorgesehen, dass der Flächenwiderstand einer Haftvermittlerschicht der Bindungsschicht größer ist als 5 Ohm/sq, bevorzugt größer als 10 Ohm/sq und besonders bevorzugt größer als 20 Ohm/sq. Der ermittelte Flächenwiderstand steht dabei im direkten Zusammenhang mit einem Anteil des Aktivmetalls in der Haftvermittlerschicht, die maßgeblich für die Anbindung der mindestens einen Metallschicht an das Isolationselement ist. Dabei nimmt der Flächenwiderstand mit abnehmenden Aktivmetallanteil in der Bindungsschicht zu. Ein entsprechend hoher Flächenwiderstand entspricht somit einem geringen Aktivmetallanteil in der Haftvermittlerschicht. Es hat sich dabei herausgestellt, dass mit zunehmenden Anteil an Aktivmetall, die Bildung von spröden intermetallischen Phasen begünstigt wird, was wiederum nachteilig ist für eine Abzugsfestigkeit der Metallschicht an die Isolationsschicht. Mit anderen Worten: Mit den anspruchsgemäßen Flächenwiderständen werden solche Bindungsschichten bereitgestellt, deren Abzugsfestigkeit aufgrund der reduzierten Bildung von spröden intermetallischen Phasen, verbessert, d. h. vergrößert wird. Durch das gezielte Einstellen der anspruchsgemäßen Flächenwiderstände lassen sich somit besonders starke Anbindungen der mindestens einen Metallschicht an das Keramikelement realisieren.

Dabei ist es zur Bestimmung des Flächenwiderstands vorgesehen, dass am gefertigten Trägersubstrat zunächst die Metallschicht und ggf. eine Lotbasisschicht, beispielsweise durch Ätzen, wieder entfernt werden. Mittels einer Vier-Punkt Messung wird dann an der Oberseite bzw. Unterseite des von der mindestens einen Metallschicht und der Lotbasisschicht befreiten Trägersubstrats ein Flächenwiderstand gemessen.

Insbesondere ist unter dem Flächenwiderstand einer Materialprobe dessen Widerstand bezogen auf einen quadratischen Oberflächenbereich zu verstehen. Es ist hierbei üblich den Oberflächenwiderstand mit der Einheit Ohm/sq zu kennzeichnen. Die Physikalische Einheit des Flächenwiderstandes ist Ohm.

Vorzugsweise ist es vorgesehen, dass eine in Stapelrichtung bemessene Dicke der Bindungsschicht, gemittelt über mehrere Messpunkte innerhalb einer vorbestimmten Fläche oder in mehreren Flächen, die parallel zur Haupterstreckungsebene verläuft oder verlaufen, einen Wert annimmt, der kleiner als 20 µm, bevorzugt kleiner als 10 µm und besonders bevorzugt kleiner als 6 µm ist. Sofern vom mehreren Flächen gesprochen wird, ist insbesondere gemeint, dass die mindestens eine Metallschicht in möglichst gleich große Flächen unterteilt wird und in jeder dieser die mindestens eine Metallschicht unterteilenden Flächen mindestens ein Wert, bevorzugt mehrere Messwerte für die Dicke erfasst werden. Die so an verschiedenen Stellen ermittelten Dicken werden arithmetisch gemittelt.

Gegenüber den aus dem Stand der Technik bekannten Trägersubstraten ist somit eine vergleichsweise dünne Bindungsschicht zwischen der mindestens einen Metallschicht und dem Isolationselement ausgebildet. Dabei ist es vorgesehen, dass zur Festlegung der maßgeblichen Dicke der Bindungsschicht die gemessenen Dicken über eine Vielzahl von Messpunkten gemittelt werden, die innerhalb einer vorbestimmten bzw. festgelegten Fläche liegen. Dadurch wird in vorteilhafter Weise mitberücksichtigt, dass das Isolationselement, insbesondere das Keramikelement, in der Regel einer Ondulation unterworfen ist, d. h. dem Isolationselement ist eine Welligkeit zuzusprechen. Insbesondere versteht der Fachmann unter einer Welligkeit eine Modulation des generellen flachen Verlaufs des Isolationselements, gesehen über mehrere Millimeter oder Zentimeter entlang einer Richtung, die parallel zur Haupterstreckungsebene verläuft. Damit grenzt sich eine derartige Ondulation von einer Oberflächenrauigkeit des Isolationselements ab, die in der Regel zusätzlich am Isolationselement vorliegt. Durch das Einbeziehen einer derartigen, in der Regel unvermeidbaren Ondulation des Isolationselements in die Bestimmung der Dicke wird berücksichtigt, dass die Bindungsschicht aufgrund der Ondulation gegebenenfalls variieren kann, insbesondere in Talbereichen des Isolationselements größer sein kann als in Bergbereichen des Isolationselements.

Ungeachtet dieser Ondulation ist der gemittelte Dickenwert dennoch deutlich geringer als derjenige, der in Trägersubstraten aus dem Stand der Technik bekannt ist. Dies wird insbesondere bzw. beispielsweise dadurch erzielt, dass eine benötigte Aktivmetallschicht zwischen dem Isolationselement und der mindestens einen Metallschicht angeordnet wird, die insbesondere einzeln, also separat angeordnet ist, beispielsweise zusätzlich zu einem Lotbasismaterial. Vorzugsweise wird das Aktivmetall mittels eines chemischen und/oder physikalischen Gasphasenabscheidens, beispielsweise mittels eines Sputterns, auf dem Lotbasismaterial und/oder der mindestens einen Metallschicht und/oder dem Isolationselement aufgetragen, um vergleichsweise dünne Aktivmetallschichten zu realisieren, die wiederrum zu einer vergleichsweise dünnen Bindungsschicht führen, insbesondere zu einer homogenen und dünnen Haftvermittlerschicht. Vorstellbar ist es auch unter Verwendung eines Plasmas, in einem Vakuum und/oder mittels Aufdampfen die Aktivmetallschicht auf dem Lotbasismaterial, dem Isolationselement und/oder der mindestens einen Metallschicht bereitzustellen. Denkbar ist auch, die Aktivmetallschicht galvanisch zu realisieren. Besonders bevorzugt ist es vorgesehen, dass die Aktivmetallschicht als Folie bereitgestellt wird.

Die Ausbildung von vergleichsweise dünnen Bindungsschichten reduziert insbesondere einen Aufwand, der aufgebracht werden muss, um beispielsweise in einem "second etching", zumindest bereichsweise, die Bindungsschicht wieder zu entfernen, um das Trägersubstrat, insbesondere dessen mindestens eine Metallschicht und die Bindungsschicht, zu strukturieren. Dies gilt insbesondere für Bereich in denen die Bindungsschicht nicht strukturiert bereitgestellt wird. Vorzugsweise erfolgt dieses Strukturieren, das dazu dient, mehrere Metallabschnitte der mindestens einen Metallschicht voneinander elektrisch zu isolieren, durch ein Ätzen und/oder ein mechanischen Bearbeitungsschritt und/oder mit Laserlicht. Außerdem hat es sich als vorteilhaft erwiesen, dass durch die Verwendung geringer Schichtdicken die Anzahl der möglichen Fehler in der Bindungsschicht, beispielsweise hervorgerufen durch Materialfehler im Lotmaterial, in vorteilhafter Weise reduziert werden kann. Unter einem Fehler in der Bindungsschicht bzw. einem Materialfehler im Lotmaterial wird beispielsweise ein großes Korn im Lotmaterial, wie beispielswiese ein Aktivmetallkorn, verstanden, das zur Riesenbildung einer Körnung in der Bindungsschicht führen kann, und/oder das nicht vollständig aufschmilzt und damit als Abstandshalter minimale Lotspalte verhindert. Durch das Auftragen, insbesondere mittels Sputtern, kann in einfacher Weise verhindert werden, dass vergleichsweise große Körner Bestandteil der Aktivmetallschicht werden. Schließlich ist es von Vorteil, dass sich homogen über das hergestellte Trägersubstrat eine dünne Bindungsschicht ausbildet.

Besonders bevorzugt ist folgendes Verfahren zur Bestimmung und Auswahl der zur Bestimmung beitragenden Messbereiche - unabhängig von der Größe des Trägersubstrats - vorgesehen:
In einem ersten Schritt wird die mindestens eine Metallschicht des Trägersubstrats in neun gleich große Rechtecke, insbesondere Quadrate, d. h. in mehrere Flächen, unterteilt. In den so festgelegten Messbereichen werden jeweils zwei oder drei Schnittbilder erzeugt, die herangezogen werden, um in jedem der Schnittbilder eine gemittelte Dicke für die mindestens eine Metallschicht zu bestimmen. Die Schnittbilder werden bevorzugt mittels eines REM-Verfahrens aufgenommen, beispielsweise in einer 2000 oder 2500- fachen Vergrößerung. Anschließend wird in einem zweiten Schritt über die insgesamt 18 oder 27 in den Schnittbildern erfassten gemittelten Dicken, die über alle neun rechteckigen Messbereiche verteilt sind, gemittelt. Auf diese Weise wird in vorteilhafter Weise sichergestellt, dass die gemittelte Dicke einen repräsentativen Wert für die Bindungsschicht zwischen der mindestens einen Metallschicht und dem Isolationselement darstellt. Mit anderen Worten: die in dem Abschnitt beschriebene Vorgehensweise sieht gemittelte Dicken vor, die über die mindestens eine Metallschicht gesehen in gleichmäßig verteilten Messbereichen bestimmt ist. Das hier beschriebene Verfahren zur Auswahl der Messbereiche, die zur Bestimmung eines gemittelten Werts für die Dicke beiträgt ist analog für die Bestimmung des Flächenwiderstands heranzuziehen.

Weiterhin ist bevorzugt vorgesehen, dass das Trägersubstrat eine Großkarte ist bzw. mehrere Subträgersubstrate eine Großkarte bilden, aus der durch Brechen entlang einer Sollbruchstelle bzw. Sollbruchlinie mehrere einzelne Substratträger entstehen, wobei die Strukturierung der Bindungsschicht der Sollbruchlinie entspricht. Dadurch ist es in vorteilhafter Weise möglich sicherzustellen, dass insbesondere die Bereiche innerhalb der die Sollbruchlinie verläuft frei sind von einer Metallisierung, die über eine ausgebildete Haftvermittlerschicht an das Isolationselement angebunden ist.

Weitere Vorteile und Eigenschaften ergeben sich aus der nachfolgenden Beschreibung bevorzugter Ausführungsformen des erfindungsgemäßen Gegenstands mit Bezug auf die beigefügten Figuren. Es zeigen:
- **Fig. 1:**: Trägersubstrat gemäß einer ersten beispielhaften Ausführungsform der vorliegenden Erfindung ;
- **Fig. 2**: Bestandteile eines Trägersubstrats gemäß einer zweiten beispielhaften Ausführungsform der vorliegenden Erfindung;
- **Fig. 3:**: Zwischenprodukt bei der Herstellung eines Trägersubstrats gemäß der zweiten beispielhaften Ausführungsform der vorliegenden Erfindung und
- **Fig. 4**: Trägersubstrat gemäß der zweiten beispielhaften Ausführungsform der vorliegende Erfindung

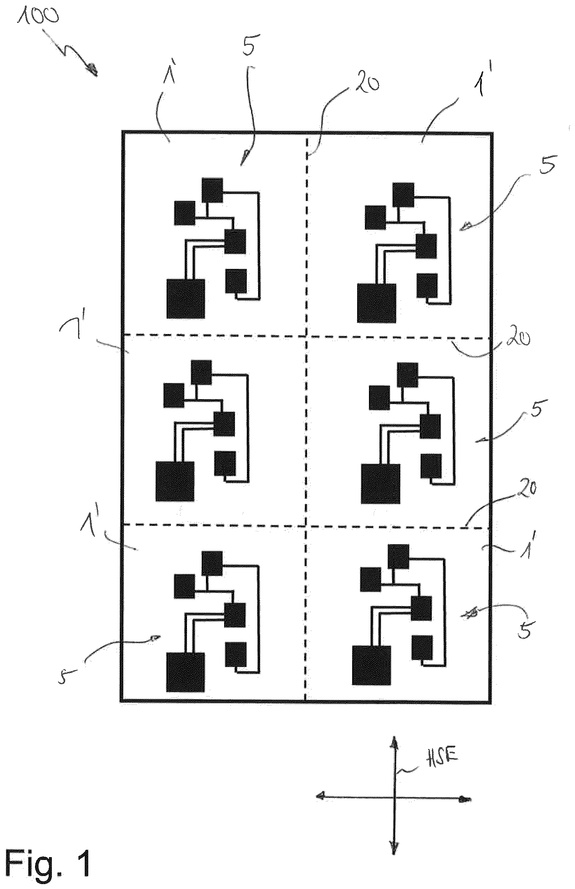

In der **Figur 1** ist ein Trägersubstrat 1 als Großkarte 100 gemäß einer ersten beispielhaften Ausführungsform der vorliegenden Erfindung dargestellt. Solche Trägersubstrate 1, insbesondere in Form eines vereinzelten Metall-Keramik-Substrats bzw. vereinzelter Subträgersubstrate 1', dienen vorzugsweise als Träger bzw. Leiterplatte für elektronische bzw. elektrische Bauteile, die an die mindestens eine Metallschicht 10 des Trägersubstrats 1 an dessen Bauteilseite anbindbar sind. Dabei ist es vorzugsweise vorgesehen, dass die mindestens eine Metallschicht 10 strukturiert ist, d. h. eine Strukturierung 5 aufweist, um entsprechende Leiterbahnen und/oder Anschlussflächen auszubilden, d. h. im gefertigten Trägersubstrat 1 umfasst die mindestens eine Metallschicht 10 mehrere voneinander elektrisch isolierte Metallabschnitte. Die sich im Wesentlich entlang einer Haupterstreckungsebene HSE erstreckende mindestens eine Metallschicht 10 und ein sich entlang der Haupterstreckungsebene HSE ersteckendes Isolationselement 30 sind dabei entlang einer senkrecht zur Haupterstreckungsebene HSE verlaufenden Stapelrichtung S übereinander angeordnet und vorzugsweise über eine Bindungsschicht 12 miteinander gefügt bzw. verbunden. Vorzugsweise umfasst das Trägersubstrat 1 neben der mindestens einen Metallschicht 10 mindestens eine weitere Metallschicht (hier nicht dargestellt), die in Stapelrichtung S gesehen an der der mindestens einen Metallschicht 10 gegenüberliegenden Seite des Isolationselements 30 angeordnet und über eine weitere Bindungsschicht an das Isolationselement 30 angebunden ist.

Dabei dient die mindestens eine weitere Metallschicht als Rückseitenmetallisierung, die einem Durchbiegen des Trägersubstrats 1, insbesondere des Metall-Keramik-Elements, entgegenwirkt, und/oder als Kühlkörper dient, der dazu ausgelegt ist, einen Wärmeeintrag, hervorgerufen durch elektrische oder elektronische Bauteile auf dem Trägersubstrat 1, abzuführen.

Insbesondere weist das Trägersubstrat 1 eine zwischen der mindestens einen Metallschicht 10 und dem Isolationselement 30 angeordnete Bindungsschicht 12 auf. Es hat sich dabei als vorteilhaft herausgestellt, wenn eine in Stapelrichtung S bemessene Dicke der Bindungsschicht 12 vergleichsweise dünn ist. Dabei erweist sich eine vergleichsweise dünne Dicke der Bindungsschicht 12 zwischen der mindestens einen Metallschicht 10 und dem Isolationselement 30 als vorteilhaft, wenn zwecks einer Strukturierung der mindestens einen Metallschicht 10 ein Ätzvorgang vorgesehen ist, insbesondere in den Bereichen, in denen keine Strukturierung der Bindungsschicht 12 vorliegt.

Insbesondere zeigt das Ausführungsbeispiel der Figur 1 ein Trägersubstrat 1 in Form einer Großkarte 100. Dabei ist es vorgesehen, dass im Rahmen einer Fertigung der Trägersubstrate 1 die mindestens eine Metallschicht 10 an das Isolationselement 30 angebunden wird und zwar bevorzugt für alle späteren Subträgersubstrate 1' der Großkarte 100. Nach dem Anbindungsprozess erfolgt die Ausbildung der Strukturierungen 5, insbesondere durch ein Ätzen und/oder eine mechanische Behandlung und/oder durch Laserlicht. Weiterhin ist es bevorzugt vorgesehen, dass nach Bereitstellen der Großkarte 100 eine Vereinzelung erfolgt, mit der die jeweiligen vereinzelten Trägersubstrate 1 bereitgestellt werden. Hierzu ist in die Großkarte 100 eine Sollbruchlinie 20 eingefügt, entlang der die Trägersubstrate 1 voneinander getrennt werden. Die in Figur 1 dargestellten Trägersubstrate 1 weisen dabei eine identische Strukturierung 5 auf. Allerdings ist es auch vorstellbar, dass sich die einzelnen Strukturierungen 5 der jeweiligen Trägersubstrate 1 innerhalb einer Großkarte 100 voneinander unterscheiden. Insbesondere ist es vorgesehen, dass die Strukturierung 5 Teil der mindestens einen Metallschicht 10 ist, die über eine Bindungsschicht 12 an das Isolationselement 10 angebunden ist.

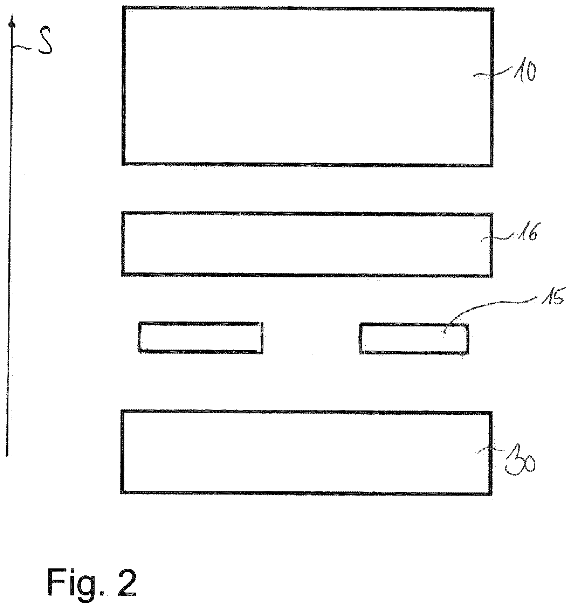

In **Figur 2** ist in einer Explosionsdarstellung ein Ensemble aus dem Isolationselement 30, der mindestens einen Metallschicht 10, einem Lotbasismaterial 16 und einer Aktivmetallschicht 15 dargestellt. Diese Bestandteile werden beispielsweise in Stapelrichtung S derart angeordnet, dass zwischen der mindestens einen Metallschicht 10 und dem Isolationselement 30 in Stapelrichtung S gesehen ein Lotsystem aus der Aktivmetallschicht 15 und dem Lotmaterial 16 angeordnet ist. Beispielsweise wird dabei das Aktivmetall zur Ausbildung der Aktivmetallschicht 15 durch ein chemisches physikalisches Gasphasenabscheiden, beispielsweise ein Sputtern, auf das Isolationselement 30 aufgetragen. Es ist auch vorstellbar, dass das Aktivmetall zur Bildung der Aktivmetallschicht 15 auf das Lotmaterial 16 aufgetragen wird, beispielsweise durch ein physikalisches Gasphasenabscheiden auf ein als Folie ausgebildetes Lotbasismaterial 16. Vorstellbar ist auch, dass die Aktivmetallschicht 15 und das Lotbasismaterial 16 jeweils als separate Folien bereitgestellt werden und/oder gemeinsam als eine zusammengewalzte Folie bereitgestellt werden.

Dabei ist es insbesondere vorgesehen, dass das Aktivmetall eine Anbindung an das Isolationselement 30 realisiert und dann zusammen mit dem Lotbasismaterial 16 in der jeweiligen Prozesstemperatur des Lotmaterials, das verwendet wird, die Bindungsschicht 12 zu formen. In dem Ausführungsbeispiel, das in Figur 2 dargestellt wird, ist es insbesondere vorgesehen, dass die Aktivmetallschicht 15 strukturiert ist. Unter einer strukturierten Aktivmetallschicht 15 ist insbesondere zu verstehen, dass innerhalb der Aktivmetallschicht 15 Abschnitte der Aktivmetallschicht 15 voneinander getrennt sind, insbesondere in einer parallel zur Haupterstreckungsebene HSE verlaufenden Richtung. Eine derart strukturierte Aktivmetallschicht 15 ist beispielsweise durch eine entsprechende Maskierung beim physikalischen Gasphasenabscheiden realisierbar oder durch eine nachträgliche Strukturierung einer Aktivmetallschicht, beispielsweise durch ein Lasern und/oder Ätzen.

Alternativ ist die als Folie verwendete Aktivmetallschicht 15 durch ein Stanzen oder Prägen in entsprechender Weise strukturiert und umfasst festgelegte und insbesondere reproduzierbar herstellbare Freibereiche bzw. Aussparungen. Dabei entspricht der Verlauf der Strukturierung der Aktivmetallschicht 15 vorzugsweise zumindest abschnittsweise der geplanten Strukturierung 5 für die mindestens eine Metallschicht 10 im gefertigten, vereinzelten Subträgersubstrat 1'. Mit anderen Worten: die Strukturierung, d. h. die Abschnitte ohne Aktivmetall in der Aktivmetallschicht 15 sind zumindest bereichsweise in Stapelrichtung S gesehen deckungsgleich angeordnet zu den späteren Freiräumen zwischen zwei Metallabschnitten in der mindestens einen Metallschicht 10.

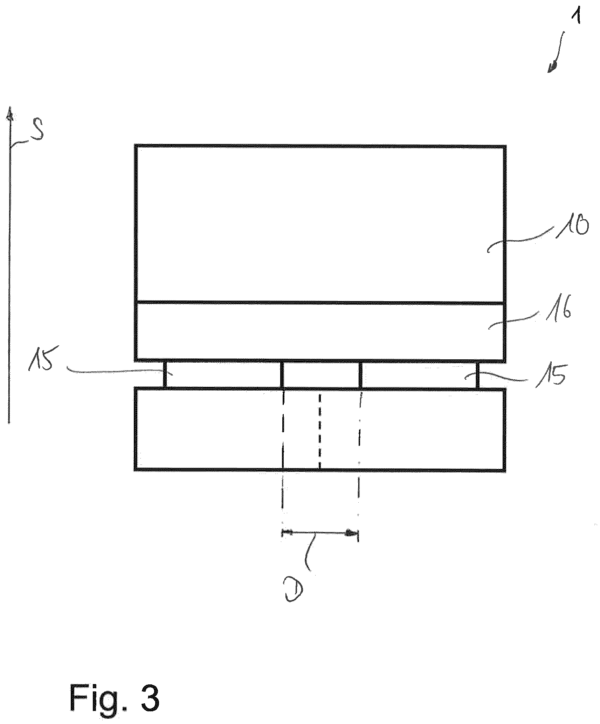

In **Figur 3** ist das in Figur 2 dargestellte Ensemble aus dem Isolationselement 30, der mindestens einen Metallschicht 10, dem Lotbasismaterial 16 und der Aktivmetallschicht 15 übereinander angeordnet. Dabei ist im angeordneten Zustand die Aktivmetallschicht 15 derart strukturiert, dass ein Abstand D zwischen zwei Abschnitten der Aktivmetallschicht 15 einen Wert zwischen 200 µm und 5 cm, bevorzugt zwischen 300 µm und 0,5 cm und besonders bevorzugt zwischen 500 µm oder 400 µm und 10 mm annimmt. Insbesondere ist es vorgesehen, dass durch die Strukturierung eine Unterbrechung in der Aktivmetallschicht 15 realisiert ist, die zwei Abschnitte der Aktivmetallschicht 15 voneinander trennt, insbesondere entlang einer Richtung, die parallel zur Haupterstreckungsebene HSE verläuft und sich vorzugsweise über mindestens 400 µm, bevorzugt mehr als 600 µm und besonders bevorzugt mehr als 800 µm erstreckt. Damit grenzt sich die Unterbrechung in der Aktivmetallschicht 15 insbesondere von solchen Freibereichen ab, die auftreten, wenn sie beispielsweise ungewollt nicht von einem Aktivmetall benetzt werden, wie es beispielsweise bei solchen Lotsystemen erfolgt, die ein Lotmaterial verwenden, bei denen sowohl Aktivmetall als auch Lotbasismaterial 16 Bestandteile derselben Paste sind.

Die Verwendung einer separaten Aktivmetallschicht 15 erweist sich ferner als besonders vorteilhaft, weil dadurch sichergestellt wird, dass eine gezielte Benetzung entlang einer gewünschten Strukturierung erfolgen kann und diese sich in der späteren Bindungsschicht 12 niederschlägt. Im Rahmen des Bindungsprozesses wird sodann in solchen Bereichen zwischen zwei Abschnitten der Aktivmetallschicht 15 keine Bindungsschicht 12 gebildet, in denen eine Aussparung in der Aktivmetallschicht 15 ausgebildet ist. Dies erweist sich insbesondere deswegen als vorteilhaft, weil in diesen Bereichen, in denen ohnehin Metall der mindestens einen Metallschicht 10 abgetragen bzw. entfernt werden muss, um die gewünschte Isolation zwischen Metallabschnitten der mindestens einen Metallschicht 10 zu realisieren, die von der Strukturierung 5 des Trägersubstrats 1 gefordert ist, nicht zusätzlich die Bindungsschicht 12 abgetragen bzw. entfernt werden muss. Es kann auf zumindest abschnittsweise auf ein "second etching" verzichtet werden, sofern keine weiteren Bestandsteile des Lotmaterials nach der Entfernung der Metallschicht verblieben sind.

Weiterhin ist es vorgesehen, dass die Unterbrechung zwischen zwei Abschnitten der Aktivmetallschicht 15 insbesondere derart angeordnet wird, dass die Unterbrechungen in Stapelrichtung S gesehen unterhalb und/oder oberhalb der Sollbruchlinie 20 bzw. der geplanten Sollbruchlinie 20 verläuft. Auch hier wird im späteren Strukturierungsverlauf Metall der mindestens einen Metallschicht 10 sowie der Bindungsschicht 12 wieder entfernt. Durch das gezielte Unterbrechen der Aktivmetallschicht 15 ist es somit möglich, das Entfernen der mindestens einen Metallschicht 10 in diesen Bereichen zu vereinfachen, insbesondere auf ein "second etching" zu verzichten oder dieses zu vereinfachen. Andernfalls müsste man in einem aufwendigen "second etching"-Verfahren die gebildete Bindungsschicht 12 bzw. Haftvermittlerschicht 13 wieder lösen.

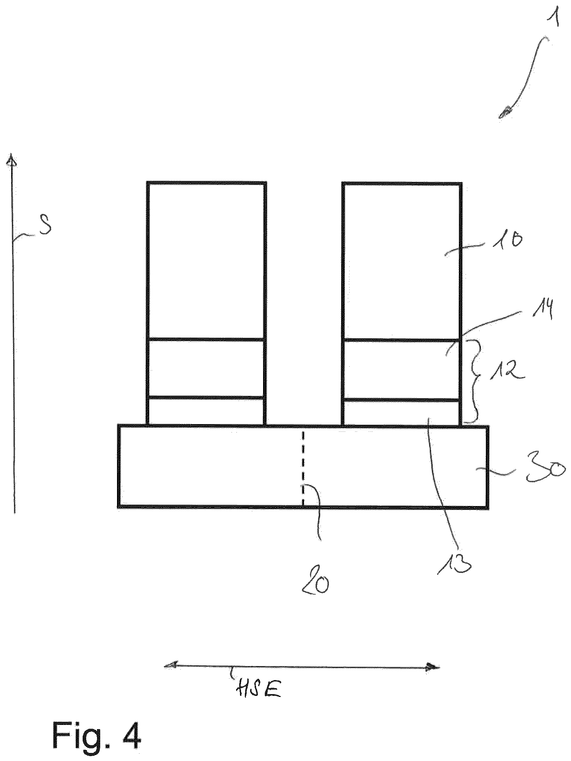

In **Figur 4** ist das Trägersubstrat 1 gemäß einer beispielhaften Ausführungsform der vorliegenden Erfindung dargestellt, insbesondere nachdem die Strukturierung 5 der mindestens einen Metallschicht 10 vollzogen wurde. Insbesondere bildet dabei das Trägersubstrat 1 eine Bindungsschicht 12 aus, die sowohl eine Haftvermittlerschicht 13 als auch eine Lotbasisschicht 14 aufweist. Beispielsweise handelt es sich bei einem silberbasierten Lotbasismaterial 16 um eine Lotbasismaterial 16, das nach der Anbindung zur Lotbasisschicht 14 wird, die im Wesentlichen aus Silber gebildet wird. Die Haftvermittlerschicht 13 setzt sich insbesondere bei Metall-Keramik-Substraten aus einer Verbindung zusammen, die zum einen das Aktivmetall, beispielsweise Titan, und einem Bestandteil der Keramik, insbesondere Sauerstoff, Kohlenstoff oder Stickstoff, aufweist. Beispielsweise ist die Haftvermittlerschicht durch Titanoxid, Titankarbid oder Titannitrid gebildet.

Die in **Figur 4** schematische Darstellung offenbart die Unterbrechung insbesondere zwischen zwei Abschnitten der mindestens einen Metallschicht 10 im Bereich oberhalb der Sollbruchlinie 20. Beispielsweise ist es vorstellbar, dass an einem Trägersubstrat 1 ausschließlich oberhalb der geplanten Sollbruchstelle 20 eine Unterbrechung der Bindungsschicht 12 ausgebildet ist, insbesondere deswegen, weil hierbei vergleichsweise große Abstände zwischen benachbarten metallischen Abschnitten denkbar sind, die wiederrum einfach durch Unterbrechungen in der Aktivmetallschicht 15 realisierbar sind.

Die in den Figuren 1 bis 4 dargestellten Ausführungsformen können beispielsweise auch durch ein Verfahren realisiert werden, bei dem auch eine Lotbasisschicht bzw. ein Lotbasismaterial verzichtet wird. Beispielsweise erfolgt hierbei die Anbindung der mindestens einen Metallschicht 10 über das Aktivmetall in der Aktivmetallschicht 15 im Rahmen eines Solid State Diffusion Bonding (SDB) vor, bei dem ein heißisostatisches Pressen erfolgt, indem ein Metallbehälter, insbesondere ein gasdichter Behälter gebildet wird, der ein Keramikelement bzw. Isolationselement 30 umschließt, wobei zwischen einer Metalllage, aus der der Metallbehälters geformt ist, eine Aktivmetallschicht 15 angeordnet ist, wobei durch Einwirken während des heißisostatischen Pressens eine Anbindung der mindestens einen Metallschicht an das Isolationselement 30 erfolgt. Dadurch wird eine Bindungsschicht 12 gebildet, die lokal geschwächt ist, nämlich in den Bereichen, in denen kein Aktivmetall zwischen dem Isolationselement 30 und der mindestens einen Metallschicht 10 angeordnet ist.

### Bezugszeichen:

- 1: Trägersubstrat
- 1': Subträgersubstrate
- 5: Strukturierung
- 10: Metallschicht
- 12: Bindungsschicht
- 13: Haftvermittlerschicht
- 14: Lotbasisschicht
- 15: Aktivmetallschicht
- 16: Lotbasismaterial
- 20: Sollbruchlinie
- 30: Isolationselement
- 100: Großkarte
- D: Abstand
- HSE: Haupterstreckungsebene
- S: Stapelrichtung

## Patentansprüche

1. Verfahren zur Herstellung eines Trägersubstrats (1), insbesondere eines Metall-Keramik-Substrates, umfassend:
- Bereitstellen mindestens einer Metallschicht (10) und eines Isolationselements (30), insbesondere eines Keramikelements (30), eines Glaselements, eines Glaskeramikelements und/oder eines hochtemperaturbeständigen Kunststoffelements, wobei sich die mindestens eine Metallschicht (10) und das Isolationselement (30) entlang einer Haupterstreckungsebene (HSE) erstrecken,
- Anordnen der mindestens einen Metallschicht (10) und des Isolationselements (30) in einer senkrecht zur Haupterstreckungsebene (HSE) verlaufenden Stapelrichtung (S) übereinander, wobei zwischen der mindestens einen Metallschicht (10) und dem Isolationselement (30) eine Aktivmetallschicht (15) angeordnet wird, wobei die Aktivmetallschicht einen Anteil an einem Aktivmetall aufweist, der größer ist als 15 Gew. - % und
- Anbinden der mindestens einen Metallschicht (10) an das Isolationselement (30) über die Aktivmetallschicht (15) unter Ausbildung einer Bindungsschicht (12) zwischen der mindestens einen Metallschicht (10) und dem Isolationselement (30),
wobei die Bindungsschicht (12) strukturiert ausgebildet wird, **dadurch gekennzeichnet, dass** zur Ausbildung der strukturierten Bindungsschicht (12) zwischen dem Isolationselement (30) und der mindestens eine Metallschicht (10) zumindest bereichsweise eine der Komponenten fehlt, die zur Bindung beitragen, oder
- die zur Bindung beitragenden Komponenten auf Abstand gehalten werden

2. Verfahren gemäß Anspruch 1, wobei zur Ausbildung der strukturierten Bindungsschicht (12) vor dem Anbindungsprozess die Aktivmetallschicht (15) und/oder das Isolationselement (30) strukturiert bereitgestellt wird.

3. Verfahren gemäß einem der vorhergehenden Ansprüche, wobei ein Lotbasismaterial (16) verwendet wird, das insbesondere zwischen der mindestens einen Metallschicht (10) und dem Isolationselement (30) angeordnet wird.

4. Verfahren gemäß Anspruch 3, wobei das Lotbasismaterial (16) strukturiert wird oder strukturiert bereitgestellt wird.

5. Verfahren gemäß einem der vorhergehenden Ansprüche, wobei die Aktivmetallschicht (15) als Folie mit Unterbrechungen zur Ausbildung der strukturierten Bindungsschicht (12) bereitgestellt wird.

6. Verfahren gemäß einem der vorhergehenden Ansprüche, wobei die Aktivmetallschicht (15) durch eine physikalisches Gasphasenabscheiden strukturiert auf das Isolationselement (30), ein Lotbasismaterial (16) und/oder die mindestens eine Metallschicht (10) aufgetragen wird und/oder wobei zur Strukturierung die Aktivmetallschicht (15) nach einem Auftragen bereichsweise wieder abgetragen wird.

7. Verfahren gemäß einem der vorhergehenden Ansprüche, wobei die Aktivmetallschicht (15) auf der mindestens einen Metallschicht (10) aufgetragen wird und nach dem Auftragen der Aktivmetallschicht (15) auf der mindestens einen Metallschicht (10) zur Bildung der Strukturierung der Aktivmetallschicht (15) bereichsweise Material der Aktivmetallschicht (15) und der mindestens einen Metallschicht (10) entfernt wird.

8. Verfahren gemäß einem der vorhergehenden Ansprüche, wobei in der mindestens einen Metallschicht (10) Gräben eingelassen werden und nach dem Ausbilden der Gräben die Aktivmetallschicht (15) aufgetragen wird.

9. Verfahren gemäß einem der vorhergehenden Ansprüche, wobei die mindestens eine Metallschicht (10) eine Dicke aufweist, die größer als 1,5 mm, bevorzugt größer als 2,5 mm und besonders bevorzugt größer als 3 mm ist.

10. Verfahren gemäß einem der vorhergehenden Ansprüche, wobei Material der Aktivmetallschicht (15) und/oder der mindestens einen Metallschicht (10) mittels Laserlicht entfernt werden.

11. Trägersubstrat (1), insbesondere ein Metall-Keramik-Substrat, als Träger für elektrische Bauteile, hergestellt mit einem Verfahren gemäß einem der vorhergehenden Ansprüche, umfassend:
- mindestens eine Metallschicht (10) und
- ein Isolationselement (30), insbesondere ein Keramikelement, ein Glaselement und/oder ein hochtemperaturbeständiges Kunststoffelement,
wobei sich die mindestens eine Metallschicht (10) und das Isolationselement (30) entlang einer Haupterstreckungsebene (HSE) erstrecken und entlang einer senkrecht zur Haupterstreckungsebene (HSE) verlaufenden Stapelrichtung (S) übereinander angeordnet sind,
wobei im Trägersubstrat (1) eine Bindungsschicht (12) zwischen der mindestens einen Metallschicht (10) und dem Isolationselement (30) ausgebildet ist, wobei die Bindungsschicht (12) vor einem Bilden von Metallabschnitten in der mindestens einen Metallschicht (10) strukturiert ist.

12. Trägersubstrat gemäß Anspruch 11, wobei eine Haftvermittlerschicht (13) der Bindungsschicht (12) einen Flächenwiderstand aufweist der größer ist als 5 Ohm/sq, bevorzugt größer als 10 Ohm/sq und besonders bevorzugt größer als 20 Ohm/sq.

13. Trägersubstrat gemäß einem der Ansprüche 11 oder 12, wobei eine in Stapelrichtung (S) bemessene Dicke der Bindungsschicht (12), gemittelt über mehrere Messpunkte innerhalb einer oder mehrere vorbestimmte Flächen, die parallel zur Haupterstreckungsebene (HSE) verläuft oder verlaufen, einen Wert annimmt, der kleiner als 20 µm, bevorzugt kleiner als 10 µm und besonders bevorzugt kleiner als 6 µm ist und/oder kleiner ist als 0,01 mm, bevorzugt kleiner als 0,005 mm und besonders bevorzugt kleiner als 0,001 oder sogar kleiner als 0,0005 mm, wenn die Bindungsschicht durch die Haftvermittlerschicht realisiert ist.

14. Trägersubstrat (1) gemäß einem der vorhergehenden Ansprüche, wobei das Trägersubstrat (1) eine Großkarte (100) ist, aus der durch Brechen entlang einer Sollbruchstelle (20) mehrere einzelne Subträgersubstrate (1') entstehen, wobei ein Verlauf der Strukturierung der Bindungsschicht einem Verlauf der Sollbruchlinie entspricht.

## Claims

1. A method of manufacturing a carrier substrate (1), in particular a metal-ceramic substrate, comprising
- providing at least one metal layer (10) and an insulating element (30), in particular a ceramic element (30), a glass element, a glass-ceramic element and/or a high-temperature resistant plastic element, wherein the at least one metal layer (10) and the insulating element (30) extend along a main extension plane (HSE),
- arranging the at least one metal layer (10) and the insulating element (30) on top of one another in a stacking direction (S) running perpendicular to the main extension plane (HSE), wherein an active metal layer (15) is arranged between the at least one metal layer (10) and the insulating element (30), wherein the active metal layer has a proportion of an active metal which is greater than 15 wt.-%, and
- bonding the at least one metal layer (10) to the insulating element (30) by the active metal layer (15), forming a bonding layer (12) between the at least one metal layer (10) and the insulating element (30),
wherein the bonding layer (12) is formed in a structured manner, **characterized in that**, for forming the structured bonding layer (12)
- between the insulating element (30) and the at least one metal layer (10), one of the components which contribute to the bond is missing at least in certain areas,
or
- the components contributing to the bond are kept at a distance.

2. The method according to claim 1, wherein the active metal layer (15) and/or the insulating element (30) is provided in a structured manner prior to the bonding process for forming the structured bonding layer (12).

3. The method according to any one of the preceding claims, wherein a solder base material (16) is used, which is arranged in particular between the at least one metal layer (10) and the insulating element (30).

4. The method according to claim 3, wherein the solder base material (16) is structured or provided in a structured manner.

5. The method according to any one of the preceding claims, wherein the active metal layer (15) is provided as a foil with discontinuities for forming the structured manner bonding layer (12).

6. The method according to one of the preceding claims, wherein the active metal layer (15) is deposited on the insulating element (30), a solder base material (16) and/or the at least one metal layer (10) in a structured manner by physical vapor deposition and/or wherein the active metal layer (15) is removed again in regions after a deposition for structuring.

7. The method according to any one of the preceding claims, wherein the active metal layer (15) is deposited on the at least one metal layer (10) and, after depositing the active metal layer (15) on the at least one metal layer (10), material of the active metal layer (15) and the at least one metal layer (10) is removed in regions to form the structuring of the active metal layer (15).

8. The method according to one of the preceding claims, wherein trenches are embedded in the at least one metal layer (10) and the active metal layer (15) is applied after forming the trenches.

9. The method according to any one of the preceding claims, wherein the at least one metal layer (10) has a thickness which is greater than 1.5 mm, more preferably greater than 2.5 mm and most preferably greater than 3 mm.

10. The method according to any one of the preceding claims, wherein material of the active metal layer (15) and/or the at least one metal layer (10) is removed by means of laser light.

11. A carrier substrate (1), in particular a metal-ceramic substrate, as a carrier for electrical components, manufactured by a method according to one of the preceding claims, comprising
- at least one metal layer (10) and
- an insulating element (30), in particular a ceramic element, a glass element and/or a high-temperature resistant plastic element,
wherein the at least one metal layer (10) and the insulating element (30) extend along a main extension plane (HSE) and are arranged on top of one another along a stacking direction (S) perpendicular to the main extension plane (HSE),
wherein a bonding layer (12) is formed in the carrier substrate (1) between the at least one metal layer (10) and the insulating element (30),
wherein the bonding layer (12) is structured manner prior to the formation of metal sections in the at least one metal layer (10).

12. The carrier substrate according to claim 11, wherein a bonding agent layer (13) of the bonding layer (12) has a sheet resistance which is greater than 5 ohm/sq, more preferably greater than 10 ohm/sq and most preferably greater than 20 ohm/sq.

13. The carrier substrate according to one of claims 11 or 12, wherein a thickness of the bonding layer (12), measured in stacking direction (S), averaged across several measuring points within one or more predetermined areas, which runs or courses parallel to the main extension plane (HSE), has a value which is smaller than 20 µm, more preferably smaller than 10 µm and most preferably smaller than 6 µm and/or smaller than 0.01 mm, more preferably smaller than 0.005 mm and most preferably smaller than 0.001 or even smaller than 0.0005 mm, if the bonding layer is realized by the bonding agent layer.

14. The carrier substrate (1) according to one of the preceding claims, wherein the carrier substrate (1) is a master card (100) from which a plurality of individual sub-carrier substrates (1') are formed by breaking along a predetermined breaking point (20), wherein a course of the structuring of the bonding layer corresponds to a course of the predetermined breaking point.

## Revendications

1. Procédé de fabrication d'un substrat de support (1), en particulier d'un substrat en métal-céramique, consistant à :
- fournir au moins une couche métallique (10) et un élément isolant (30), en particulier un élément en céramique (30), un élément en verre, un élément en vitrocéramique et/ou un élément en matière plastique à haute résistance thermique, ladite au moins une couche métallique (10) et l'élément isolant (30) s'étendant le long d'un plan d'extension principale (HSE),
- disposer ladite au moins une couche métallique (10) et l'élément isolant (30) l'un au-dessus de l'autre dans une direction d'empilement (S) s'étendant perpendiculairement au plan d'extension principale (HSE), une couche de métal actif (15) étant disposée entre ladite au moins une couche métallique (10) et l'élément isolant (30), la couche de métal actif ayant une proportion en métal actif qui est supérieure à 15 % en poids, et
- relier ladite au moins une couche métallique (10) à l'élément isolant (10) par l'intermédiaire de la couche de métal actif (15) en formant une couche de liaison (12) entre ladite au moins une couche métallique (10) et l'élément isolant (30), la couche de liaison (12) étant réalisée de façon structurée,
**caractérisé en ce que**, pour réaliser la couche de liaison structurée (12),
- l'un des composants contribuant à la liaison manque au moins localement entre l'élément isolant (30) et ladite au moins une couche métallique (10), ou
- les composants contribuant à la liaison sont maintenus à distance.

2. Procédé selon la revendication 1,
dans lequel, pour réaliser la couche de liaison structurée (12), la couche de métal actif (15) et/ou l'élément isolant (30) sont fournis de manière structurée, avant le processus de liaison.

3. Procédé selon l'une des revendications précédentes,
dans lequel on utilise un matériau de base de brasage (16) qui est en particulier disposé entre ladite au moins une couche métallique (10) et ledit élément isolant (30).

4. Procédé selon la revendication 3,
dans lequel le matériau de base de brasage (16) est structuré ou est fourni de façon structurée.

5. Procédé selon l'une des revendications précédentes,
dans lequel la couche de métal actif (15) est fournie sous forme de feuille avec des interruptions pour former la couche de liaison structurée (12).

6. Procédé selon l'une des revendications précédentes,
dans lequel la couche de métal actif (15) est appliquée de manière structurée sur l'élément isolant (30), sur un matériau de base de brasage (16) et/ou sur ladite au moins une couche métallique (10) par un dépôt physique en phase vapeur, et/ou
pour la structuration, la couche de métal actif (15) est enlevée localement après avoir été appliquée.

7. Procédé selon l'une des revendications précédentes,
dans lequel la couche de métal actif (15) est appliquée sur ladite au moins une couche métallique (10) et, après l'application de la couche de métal actif (15) sur ladite au moins une couche métallique (10), le matériau de la couche de métal actif (15) et de ladite au moins une couche métallique (10) est enlevé localement pour former la structuration de la couche de métal actif (15).

8. Procédé selon l'une des revendications précédentes,
dans lequel des tranchées sont formées dans ladite au moins une couche métallique (10), et la couche de métal actif (15) est appliquée après la formation des tranchées.

9. Procédé selon l'une des revendications précédentes,
dans lequel ladite au moins une couche métallique (10) présente une épaisseur supérieure à 1,5 mm, de préférence supérieure à 2,5 mm et de manière particulièrement préférée supérieure à 3 mm.

10. Procédé selon l'une des revendications précédentes,
dans lequel le matériau de la couche de métal actif (15) et/ou de ladite au moins une couche métallique (10) est enlevé au moyen d'une lumière laser.

11. Substrat de support (1), en particulier substrat en métal-céramique, à titre de support pour des composants électriques, fabriqué par un procédé selon l'une des revendications précédentes, comprenant :
- au moins une couche métallique (10) et
- un élément isolant (30), en particulier un élément en céramique, un élément en verre et/ou un élément en matière plastique à haute résistance thermique, dans lequel
ladite au moins une couche métallique (10) et l'élément isolant (30) s'étendent le long d'un plan d'extension principale (HSE) et sont disposés l'un au-dessus de l'autre dans une direction d'empilement (S) s'étendant perpendiculairement au plan d'extension principale (HSE),
dans le substrat de support (1), une couche de liaison (12) est réalisée entre ladite au moins une couche métallique (10) et l'élément isolant (30), la couche de liaison (12) étant structurée avant une formation de portions métalliques dans ladite au moins une couche métallique (10).

12. Substrat de support selon la revendication 11,
dans lequel une couche d'agent adhésif (13) de la couche de liaison (12) présente une résistivité superficielle qui est supérieure à 5 ohms/carré, de préférence supérieure à 10 ohms/carré et de manière particulièrement préférée supérieure à 20 ohms/carré.

13. Substrat de support selon l'une des revendications 11 ou 12,
dans lequel une épaisseur de la couche de liaison (12), mesurée dans la direction d'empilement (S), moyennée sur plusieurs points de mesure à l'intérieur d'une ou de plusieurs surfaces prédéterminées parallèles au plan d'extension principale (HSE), prend une valeur qui est inférieure à 20 µm, de préférence inférieure à 10 µm et de manière particulièrement préférée inférieure à 6 µm et/ou inférieure à 0,01 mm, de préférence inférieure à 0,005 mm et de manière particulièrement préférée inférieure à 0,001 ou même inférieure à 0,0005 mm, lorsque la couche de liaison est réalisée par la couche d'agent adhésif.

14. Substrat de support (1) selon l'une des revendications précédentes,
dans lequel
le substrat de support (1) est une grande carte (100) à partir de laquelle plusieurs sous-substrats de support (1') individuels se forment par rupture le long d'une ligne destinée à la rupture (20), un tracé de la structuration de la couche de liaison correspondant à un tracé de la ligne destinée à la rupture.
